# EUROPÄISCHE PATENTANMELDUNG

(11) **EP 1 772 906 A1**
(43) Veröffentlichungstag der Anmeldung: **11.04.2007**
(21) Anmeldenummer: 06018403.3
(22) Anmeldetag: 02.09.2006
(51) Int. Cl.: H01L 29/78, H01L 29/165, H01L 29/08, H01L 21/336, H01L 29/161, H01L 21/266

(54) **Hochvolt-Feldeffekttransistor und Verfahren zur Herstellung eines Hochvolt-Feldeffekttransistors**

(30) Priorität: 09.09.2005 DE 102005042827
(71) Anmelder: ATMEL Germany GmbH, 74072 Heilbronn (DE)
(72) Erfinder: Schwantes, Stefan, Dr., 74080 Heilbronn (DE); Dudek, Volker, Dr., 76275 Ettlingen (DE); Graf, Michael, Dr., 71397 Lentenbach (DE)

(57) **Zusammenfassung**

Hochvolt-Feldeffekttransistor mit einem Bodyhalbleitergebiet (30), das teilweise an ein Gate-Oxid (89) zur Ausbildung eines Kanals angrenzt und das an ein Bodyanschlusshalbleitergebiet (31) und an ein Sourcehalbleitergebiet (12) angrenzt, und mit einem Drifthalbleitergebiet (10), das an ein Drainhalbleitergebiet (11) und an das Bodyhalbleitergebiet (30) angrenzt,

wobei im Drifthalbleitergebiet (10) in einem vom Bodyhalbleitergebiet (30) distanzierten Bereich (50) eine Potentialbarriere (pb) ausgebildet ist.
Zur Ausbildung der Potentialbarriere (pb) wird die Bandlücke mit distanzierten Bereich (50) gegenüber anderen Bereichen des Drifthalbleitergebietes (10) verkleinert.

## Beschreibung

Die vorliegende Erfindung betrifft einen Hochvolt-Feldeffekttransistor und ein Verfahren zur Herstellung eines Hochvolt-Feldeffekttransistors.

Aus der US 5,698,869 ist eine Halbleiterstruktur und die Herstellung einer Halbleiterstruktur bekannt, in der für einen Transistor mit isoliertem Gate, wie einem MOSFET, der Leckstrom reduziert und die Durchbruchspannung erhöht ist. Eine Halbleiterregion mit gegenüber Silizium verringerten Bandabstand, wie SiₓGe₁₋ₓ, SiₓSn₁₋ₓ oder PbS wird in einem Innenbereich einer Sourceregion oder einer Drainregion eines SOI-Bauelements ausgebildet. Um den potentialfreier-Body-Effekt in einem SOI-Bauelement wirkungsvoll zu unterdrücken, muss der SiGe-Bereich ausreichend nahe an einem pn-Übergang zwischen der Sourceregion und einer Kanalregion ausgebildet sein. Um den Einfluss von Kristallstörungen durch die Germaniumatome zu reduzieren, wird vorgeschlagen, den Bereich mit verringertem Bandabstand bis in die Kanalregion hin auszubilden.

In der JP 06013561 A (engl. abstract) wird Germanium in die Source- und Drainregion eines MOSFETs implantiert, so dass der Bandabstand in der Sourceregion und in der Drainregion reduziert ist, um eine Stromverstärkung eines parasitären Bipolartransistors zu reduzieren. Ähnliches zeigt die US 6,765,247 B2. In der JP 07335887 A wird zudem eine horizontale Konzentrationsverteilung des Germaniums über zwei Schritte der Germanium-Implantation in einem gewöhnlichen LDD Prozess erreicht.

Die US 6,828,632 B2 betrifft eine SOI-Struktur. Eine Wannenregion ist dabei über einer Oxid-Schicht ausgebildet. Die Wannenregion ist in mehreren Schichten epitaktisch aufgebracht worden, wobei die Schichten eine Silizium-Germanium-Schicht aufweisen. Die Silizium-Germanium-Schicht weist eine Anzahl von Rekombinationszentren in den Source-/Drainregionen auf.

Aus der US 6,787,883 B1 ist es bekannt, in der Kanalregion eine Si₁₋ₓGeₓ-Schicht herzustellen, die gegenüber dem Substrat einen Si₁₋ₓGeₓ-Si Heteroübergang ausbildet. Zur Reduktion von heißen Ladungsträgern wird in der US 5,134,447 in den Body eines MOS-Transistors in die Nähe zu einem pn-Übergang den Heteroübergang ausgebildet.

Aus der US 6,531,748 B2 ist ein Leistungsbauelement mit einer MOS-Struktur bekannt. Die Source-Region ist dabei aus einem Material ausgebildet, dass einen geringeren Bandabstand als das Material einer Kanalregion aufweist, um eine Stromverstärkung eines parasitären Bipolartransistors zu reduzieren.

Der Erfindung liegt die Aufgabe zu Grunde, einen Hochvolt-Feldeffekttransistor, der ein Drifthalbleitergebiet aufweist, weiter zu entwickeln.

Diese Aufgabe wird erfindungsgemäß durch ein Verfahren mit den Merkmalen des Anspruchs 8 und durch einen Hochvolt-Feldeffekttransistor mit den Merkmalen des Anspruchs 1 gelöst. Bevorzugte Weiterbildungen der Erfindung sind Gegenstand von Unteransprüchen.

Demgemäß ist ein Hochvolt-Feldeffekttransistor vorgesehen. Ein Hochvolt-Feldeffekttransistor ist durch ein Drifthalbleitergebiet charakterisiert. Über dieses Drifthalbleitergebiet, das auch als Driftzone bezeichnet werden kann, bildet sich beim Anlegen einer Drain-Source-Spannung ein elektrisches Feld aus. Um als Hochvolt-Feldeffekttransistor eine hohe Sperrspannung auszubilden, darf das elektrische Feld entlang des Drifthalbleitergebietes einen Maximalwert nicht überschreiten.

Weiterhin weist der Hochvolt-Feldeffekttransistor einen Drain-Anschluss, einen Source-Anschluss, einen Body-Anschluss und einen Gate-Anschluss auf. Ein Gate-Oxid und eine an das Gate-Oxid angrenzende Gate-Elektrode, die mit dem Gate-Anschluss verbunden ist, ermöglichen eine Steuerung des Hochvolt-Feldeffekttransistors.

Ein Drainhalbleitergebiet eines ersten Leitungstyps ist mit dem Drain-Anschluss verbunden. Ein Sourcehalbleitergebiet des ersten Leitungstyps ist mit dem Source-Anschluss verbunden. Ein Bodyanschlusshalbleitergebiet eines zweiten - dem ersten Leitungstyp entgegengesetzten - Leitungstyps ist mit dem Body-Anschluss verbunden. Ein Bodyhalbleitergebiet des zweiten Leitungstyps, das teilweise an das Gate-Oxid zur Ausbildung eines Kanals angrenzt, grenzt zudem an das Bodyanschlusshalbleitergebiet an.

Das Drifthalbleitergebiet des ersten Leitungstyps grenzt an das Drainhalbleitergebiet und an das Bodyhalbleitergebiet an. Bei einem Hochvolt-Feldeffekttransistor ist die wirksame Länge des Drifthalbleitergebietes dabei das Zwei- oder Mehrfache der Länge des Kanalgebietes.

Im Drifthalbleitergebiet ist in einem vom Bodyhalbleitergebiet räumlich entfernten Bereich eine Potentialbarriere ausgebildet. Die Distanz zwischen diesem Bereich im Drifthalbleitergebiet und dem Bodyhalbleitergebiet ist dabei dann ausreichend groß, wenn im Falle einer angelegten Drain-Source-Spannung eine Wechselwirkung zwischen dem pn-Übergang und der Potentialbarriere zu vernachlässigen ist.

In einer bevorzugten Ausgestaltung der Erfindung ist vorgesehen, dass zur Ausbildung der Potentialbarriere die Bandlücke in diesem Bereich gegenüber anderen Bereichen des Drifthalbleitergebietes verkleinert ist. Die Bandlücke, die auch als Energielücke oder Bandabstand bezeichnet wird, beträgt beispielsweise für Silizium 1,12 eV. Wird beispielsweise Germanium in diesen Bereich zur Ausbildung der Potentialbarriere eingebracht, kann die Bandlücke auf einen Wert zwischen 0,67 eV (Ge) bis 1,1 eV für ein Silizium-Germanium-Mischkristall (SiGe) verkleinert werden. Die Potentialbarriere weist für einen N-DMOS-Feldeffektransistor vorzugsweise eine abrupte Änderung im Valenzband auf.

Die abrupte Änderung im Valenzband ist dabei derart ausgebildet, dass in Richtung des Bodyhalbleitergebietes fließende Löcher zum überwiegenden Teil gestoppt werden. Hingegen weist die Potentialbarriere für einen P-DMOS-Feldeffektransistor eine abrupte Änderung im Leitungsband auf. Die abrupte Änderung im Leitungsband ist dabei derart ausgebildet, dass in Richtung des Bodyhalbleitergebietes fließende Elektronen zum überwiegenden Teil gestoppt werden. Grundsätzlich können erfindungsgemäß auch andere Halbleiter, wie Gallium-Arsenid (GaAs) oder Silizium-Karbid (SiC) verwendet werden.

Gemäß einer bevorzugten Weiterbildung der Erfindung weist das Drifthalbleitergebiet monokristallines Silizium auf. In diesem Bereich mit der Potentialbarriere sind in das monokristalline Silizium des Drifthalbleitergebietes Germaniumatome eingebracht. Dabei nimmt in diesem Bereich die Konzentration der Germaniumatome in Richtung des Drainhalbleitergebietes ab. Die abnehmende Konzentration von Germanium bewirkt, dass im Falle eines N-DMOS-Feldeffekttransistors Elektronen nicht durch eine Potentialbarriere behindert werden, so dass der Einschaltwiderstand des Hochvolt-Feldeffekttransistors gering bleibt.

In einer bevorzugten Weiterbildung der Erfindung weist der Hochvolt-Feldeffekttransistor ein Feldoxid auf, das um ein Mehrfaches dicker ist als das Gate-Oxid. Der Bereich mit der Potentialbarriere grenzt innerhalb des Drifthalbleitergebietes vorzugsweise an das Feldoxid an.

Gemäß einer anderen vorteilhaften Weiterbildung der Erfindung weist der Hochvolt-Feldeffekttransistor eine vergrabene Isolatorschicht auf. Diese Isolatorschicht ist beispielsweise aus Siliziumdioxid. Zum Vergraben dieser Isolatorschicht können beispielsweise ein erster Wafer und ein zweiter Wafer mit einer Deckschicht aus Siliziumdioxid aufeinander gebondet werden. Vorzugsweise grenzt der Bereich mit der Potentialbarriere an die vergrabene Isolatorschicht an. Zusätzlich zur Isolatorschicht, die den Hochvolt-Feldeffekttransistor gegenüber einem Substrat isoliert, kann der Feldeffekttransistor durch einen mit einem Isolationsmaterial gefüllten Graben gegenüber lateral auf dem Chip benachbarte Bauelemente isoliert sein.

Zusätzlich zur Ausbildung der Potentialbarriere ist in einer Ausgestaltung der Erfindung im Sourcehalbleitergebiet und/oder im Drainhalbleitergebiet eine weitere Potentialbarriere ausgebildet. Diese weitere Potentialbarriere kann andere physikalische Wirkungen zur Vergrößerung der Durchbruchspannung oder zur Verringerung des Einschaltwiderstandes erzeugen.

Weiterhin wird die erfindungsgemäße Aufgabe durch ein Verfahren zur Herstellung eines Hochvolt-Feldeffekttransistors gelöst. Dabei werden ein Drifthalbleitergebiet und ein Bodyhalbleitergebiet aus einem ersten Halbleitermaterial ausgebildet. In das Drifthalbleitergebiet wird ein zweites Halbleitermaterial zur Ausbildung einer Potentialbarriere derart eingebracht, dass eine Konzentration des zweiten Halbleitermaterials in dem ersten Halbleitermaterial in Richtung eines Drainhalbleitergebietes abnimmt.

Um die abnehmende Konzentration des zweiten Halbleitermaterials, beispielsweise Germanium, zu bewirken, ist in einer Ausgestaltung der Erfindung vorgesehen, dass eine Implantationsmaskierung verwendet wird. Eine Implantation mit dieser vorzugsweise geschlitzten Implantationsmaske ermöglicht die bezüglich einer Oberfläche des zu prozessierenden Wafers laterale Ausbildung der abnehmenden Konzentration des zweiten Halbleitermaterials im Drifthalbleitergebiet.

Gemäß einer anderen Ausbildung der Erfindung ist eine vertikale Ausbildung eines Konzentrationsgradienten vorgesehen. Um diesen bezüglich einer Oberfläche des zu prozessierenden Wafers vertikalen Konzentrationsgradienten mit abnehmender Konzentration des zweiten Halbleitermaterials auszubilden, wird eine Zufuhr des zweiten Halbleitermaterials während einer epitaktischen Abscheidung geändert.

In einer Weiterbildung der Erfindung ist vorgesehen, dass vorzugsweise unmittelbar nach der Potentialbarriere ein an die Potentialbarriere angrenzendes Feldoxid ausgebildet wird. Dieses Feldoxid kann dabei durch Oxidation des ersten Halbleitermaterials, beispielsweise Silizium, oder durch Abscheidung eines Oxids erzeugt werden.

Im Folgenden wird die Erfindung in einem Ausführungsbeispiel anhand von Zeichnungen mit den Figuren 1 bis 3 näher erläutert.

Dabei zeigen
- Fig. 1: eine schematische Schnittansicht durch einen Hochvolt-Feldeffekttransistor,
- Fig. 2: ein schematisches Bändermodell mit der in Fig. 1 ausgebildeten Potentialbarriere,

- Fig. 3: eine schematische Darstellung eines lateralen Gradienten einer Konzentration von Germanium in einem Siliziumhalbleitermaterial, und
- Fig. 4: eine schematische Darstellung einer Maskierung zur Erzeugung eines lateralen Gradienten einer Konzentration von Germanium in einem Siliziumhalbleitermaterial.

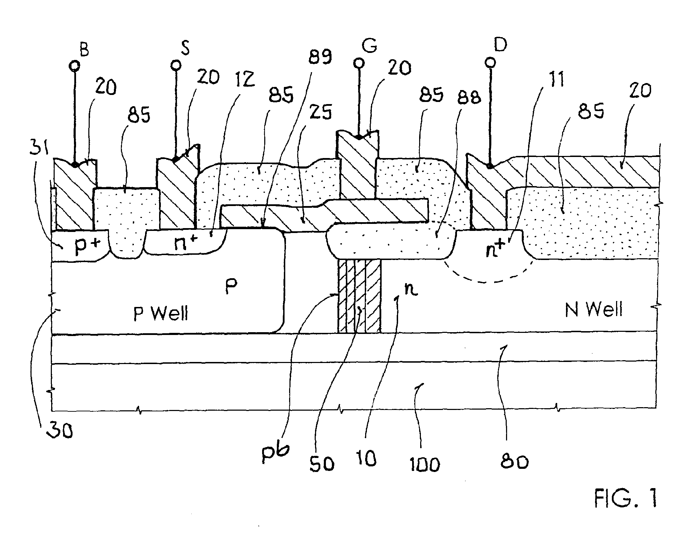

In der Fig. 1 ist eine Schnittansicht durch einen Hochvolt-Feldeffekttransistor schematisch dargestellt. Der Hochvolt-Feldeffekttransistor hat Anschlüsse Drain D, Gate G, Source S und Body B, die jeweils eine Metallstruktur 20 zur Verbindung durch Leiterbahnen aufweisen. Dabei können der Source-Anschluss S und der Body-Anschluss B über eine Metallleiterbahn kurzgeschlossen sein. Die Metallstrukturen 20 sind beispielsweise über eine in Fig. 1 nicht dargestellte Silizidschicht mit einer Halbleiterregion 11, 12, 25 und 31 des Hochvolt-Feldeffekttransistors verbunden. Die Metallstruktur 20 des Gate-Anschlusses G grenzt dabei an die Gate-Elektrode 25, die aus hochdotiertem polykristallinem Silizium ausgebildet ist.

In Fig. 1 ist beispielhaft ein N-DMOS-Feldeffekttransistor dargestellt. Die Metallstruktur 20 des Drain-Anschlusses D ist beispielsweise über ein Silizid mit einem Drainhalbleitergebiet 11 verbunden. Das Drainhalbleitergebiet 11 ist dabei n-dotiert. Ebenfalls n-dotiert ist das Sourcehalbleitergebiet 12, das mit der Metallstruktur 20 des Source-Anschlusses S verbunden ist.

Die Metallstruktur des Body-Anschlusses B ist mit einem hochdotierten Bodyanschlusshalbleitergebiet 31 verbunden. Das Bodyanschlusshalbleitergebiet 31 ist dabei p-dotiert. Weiterhin p-dotiert ist das Bodyhalbleitergebiet 30, das an das Bodyanschlusshalbleitergebiet 31 grenzt. Weiterhin reicht das Bodyhalbleitergebiet 30 bis unter ein dünnes Gate-Oxid 89, das unterhalb der Gateelektrode 25 ausgebildet ist. Das Bodyhalbleitergebiet 30 wird in Fig. 1 auch als PWell bezeichnet. Das Bodyhalbleitergebiet 30 bildet zudem einen pn-Übergang zum Sourcehalbleitergebiet 12.

Ein weiterer pn-Übergang ist zwischen dem Bodyhalbleitergebiet 30 und einem Drifthalbleitergebiet 10 ausgebildet. Das Drifthalbleitergebiet 10 wird auch als Driftzone und in Fig. 1 auch als NWell bezeichnet. Wird eine Gatespannung zwischen dem Gate-Anschluss G und dem Source-Anschluss S unterhalb einer Schwellenspannung des Hochvolt-Feldeffekttransistors angelegt, fällt eine Sperrspannung in Sperrrichtung über den pn-Übergang zwischen dem Bodyhalbleitergebiet 30 und dem Drifthalbleitergebiet 10 ab.

N-DMOS Transistoren werden physikalisch beschädigt, wenn aufgrund einer hohen, zwischen dem Drain-Anschluss D und dem mit dem Body-Anschluss B verbundenen Source-Anschluss S anliegenden Spannung ein parasitärer Bipolartransistor gezündet wird. Der parasitäre Bipolartransistor in Fig. 1 ist durch das Drifthalbleitergebiet 10 als parasitäres Kollektorgebiet, durch das Bodyhalbleitergebiet 30 als parasitäres Basisgebiet und durch das Sourcehalbleitergebiet 12 als parasitäres Emittergebiet gebildet.

Es kann aufgrund der hohen anliegenden Drain-Source-Spannung dabei zu einem dramatischen Anstieg des Drainstromes kommen, der nicht mehr vom Gate-Potential kontrolliert werden kann. Der unkontrollierte Stromfluss führt schließlich zur thermischen Zustörung des Bauelementes. Der parasitäre Bipolartransistor wird dabei durch einen Löcherstrom aufgesteuert. Beispielsweise an Kristalldefekten generierte Ladungsträger werden durch ein elektrisches Feld in der Raumladungszone, welche sich entlang des Drifthalbleitergebietes 10 zwischen dem Drainhalbleitergebiet 11 und dem pn-Übergang (Bodyhalbleitergebiet 30 / Drifthalbleitergebiet 10) ausbildet, beschleunigt.

Durch Stoßionisation kann wiederum ein Elektron-Loch-Paar generiert werden. Die Elektronen wandern dabei zum Drainhalbleitergebiet 11, die Löcher hingegen fließen über das Bodyhalbleitergebiet 30 und weiter über das Bodyanschlusshalbleitergebiet 31 ab. Wenn der Spannungsabfall am Sourcehalbleitergebiet 12, hervorgerufen durch den Löcherstrom Richtung Bodyanschlusshalbleitergebiet 31 ausreicht, um den Sourcehalbleitergebietzu-Bodyhalbleitergebiet-pn-Übergang in Flussrichtung zu schalten, wird der parasitäre bipolare Transistor gezündet.

Die zwischen Drain-Anschluss D und den kurzgeschlossenen Source- D und Body-Anschlüssen B anliegende Spannung muss daher immer unterhalb eines kritischen Wertes bleiben, so dass der durch die generierten Ladungsträger hervorgerufene Spannungsabfall nicht ausreicht, um den pn-Übergang zwischen Sourcehalbleitergebiet 12 und Bodyhalbleitergebiet 30 in Flussrichtung zu polen.

Innerhalb des Drifthalbleitergebietes 10 ist ein Bereich 50 mit einer Potentialbarriere pb ausgebildet. Der Löcherstrom vom Drifthalbleitergebiet 10 zur Bodyhalbleitergebiet 30 wird durch die Potentialbarriere pb unterdrückt. In dem Bereich 50 ist die Bandlücke durch in Silizium eingebrachte Germaniumatome lokal verkleinert. Außerhalb des Bereichs 50 ist die Bandlücke des Siliziums zwischen Leitungsband und Valenzband hingegen nicht verkleinert.

Der Bereich 50 und damit die Potentialbarriere pb sind außerhalb des Drainhalbleitergebietes 11, außerhalb des Bodyhalbleitergebietes 30 und außerhalb des Sourcehalbleitergebietes 12 ausgebildet. Zudem ist der Bereich 50 mit den eingebrachten Germaniumatomen von dem Bodyhalbleitergebiet 30 beabstandet. Weiterhin ist der Bereich 50 von dem Gate-Oxid 89 beabstandet. Vorzugsweise liegen die Beabstandungen im Bereich um 200nm Das Ausführungsbeispiel in der Fig.1 ist dabei nicht maßstabsgetreu dargestellt.

Die Fig. 1 zeigt ein gegenüber dem Gate-Oxid 89 dickeres Feldoxid 88, wobei der Bereich 50 und damit die Potentialbarriere pb an das Feldoxid 88 angrenzen. Das Drifthalbleitergebiet 10 und das Bodyhalbleitergebiet 30 grenzen zudem an eine vergrabene Oxid-Schicht 80 (SOI). Vorteilhafterweise grenzt ebenfalls der Bereich 50 und vorzugsweise auch die Potentialbarriere pb an die vergrabene Oxid-Schicht 80.

Anstelle des in Fig. 1 dargestellten N-DMOS gilt gleiches für den P-DMOS analog. In diesem Fall sind die in Fig. 1 dargestellten Leitungstypen n und p gegeneinander auszutauschen.

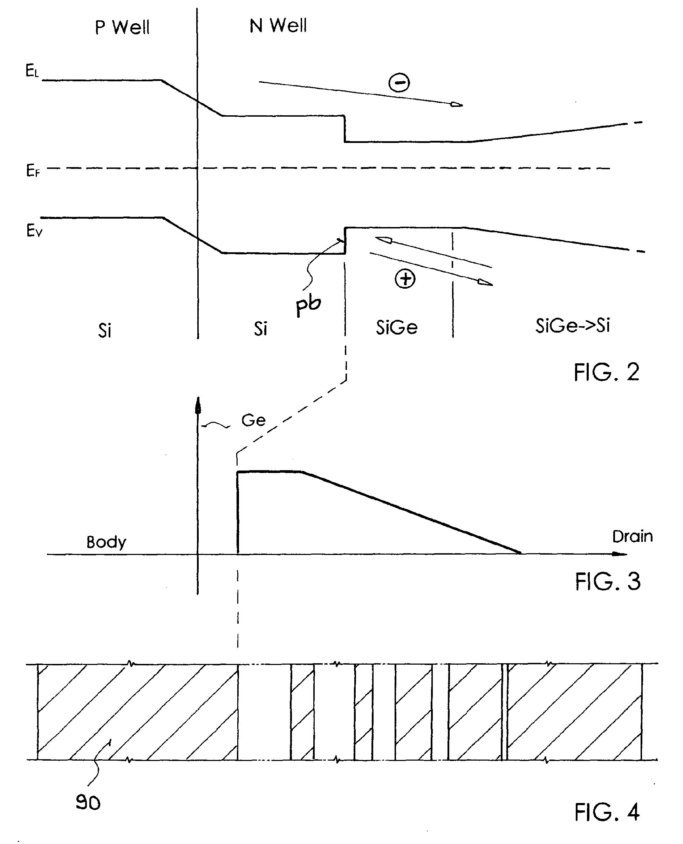

In Fig. 2 ist ein vereinfachtes Bändermodell mit einem Leitungsband E_{L}, einem Valenzband E_{V} und einem Fermi-Niveau E_{F} ohne an den Drainanschluss D angelegte Spannung schematisch dargestellt. Das p-dotierte Bodyhalbleitergebiet PWell, 30 ist in Fig. 2 linksseitig dargestellt. Der senkrecht eingezeichnete Strich stellt den pn-Übergang zwischen dem Bodyhalbleitergebiet PWell, 30 und dem angrenzenden Drifthalbleitergebiet NWell, 10 dar. Im pn-Übergangsbereich verändern sich die Abstände des Leitungsbands E_{L} und des Valenzband E_{V} bezüglich des Fermi-Niveaus E_{F}. In diesem pn-Übergangsbereich liegt außerhalb des Bereichs 50 und ist damit in einem Siliziumkristall Si ausgebildet.

Weiterhin ist in Fig. 2 die Potentialbarriere pb eingezeichnet. In der Fig. 2 rechts von der Potentialbarriere pb, also in Richtung des Drainhalbleitergebietes 11, ist im Bereich 50 Germanium Ge in das Silizium Si eingebracht, so dass ein Silizium-Germanium-Mischkristall SiGe ausgebildet ist. Dieses Silizium-Germanium-Mischkristall SiGe weist eine gegenüber dem Siliziumkristall Si kleinere Banklücke auf, wie in Fig. 2 dargestellt ist. Die kleinere Bandlücke des Silizium-Germanium-Mischkristalls SiGe, die an das Siliziumkristall Si angrenzt, bewirkt die Potentialbarriere pb. Der Übergang vom Gebiet großer Bandlücke im Siliziumkristall Si zum Gebiet schmaler Bandlücke im Silizium-Germanium-Mischkristall SiGe ist abrupt.

Die entstehende Potentialbarriere pb wirkt dabei ausschließlich im Valenzband E_{V} gegen ein Abfließen der Löcher (+) zum Bodyhalbleitergebiet 30 und Bodyanschlusshalbleitergebiet 31. Der Sprung im Leitungsband E_{L} wirkt sich dabei nicht negativ auf den Elektronenstrom (-) aus. In Richtung des Drainhalbleitergebietes 11 erfolgt der Übergang vom Gebiet schmaler Bandlücke zum Gebiet großer Bandlücke fließend um eine Elektronen-Potentialbarriere zu vermeiden. Innerhalb einer Mindestdistanz in dem Bereich 50 wird dies durch ein in Richtung Drainhalbleitergebiet 11 kontinuierlich fallendes Dotierungsprofil für Germanium Ge erzielt.

In Fig. 3 ist ein ist beispielhaft ein annähernd lineares Dotierungsprofil dargestellt. Um ein derartiges annähernd lineares Dotierungsprofil zu erhalten, werden die Germaniumatome Ge durch eine geschlitzte Maskierung 90, wie diese in Fig. 4 dargestellt ist, in das Drifthalbleitergebiet 10 implantiert. In einem späteren Hochtemperaturschritt kann die Verteilung des Germaniums Ge noch verändert, insbesondere linearisiert werden.

### Bezugszeichenliste

- 10, NWell: Drifthalbleitergebiet
- 11: Drainhalbleitergebiet
- 12: Sourcehalbleitergebiet
- 20: Metallisierung, Metallbahn, Leiterbahn
- 25: Polysilizium-Gate-Elektrode
- 30, PWell: Bodyhalbleitergebiet
- 31: Bodyanschlusshalbleitergebiet
- 50: Bereich im Drifthalbleitergebiet mit Ge
- 80: vergrabene Oxid-Schicht (SOI)
- 85: Passivierung, Oxid-Schicht
- 88: Feld-Oxid
- 89: Gate-Oxid
- 90: Maskierung
- 100: Substrat
- pb: Potentialbarriere
- Si: Silizium
- Ge: Germanium
- SiGe: Silizium-Germanium-Mischkristall
- B: Body-Anschluss (Substrat)
- G: Gate-Anschluss (Tor)
- D: Drain-Anschluss (Senke)
- S: Source-Anschluss (Quelle)
- (-): Elektronen
- (+): Löcher
- E_{L}: Leitungsband
- E_{V}: Valenzband
- E_{F}: Fermi-Niveau

## Patentansprüche

1. Hochvolt-Feldeffekttransistor
- mit einem Drain-Anschluss (D), einem Source-Anschluss (S), einem Body-Anschluss (B) und einem Gate-Anschluss (G),
- mit einem Gate-Oxid (89) und einer an das Gate-Oxid (89) angrenzenden Gateelektrode (25), die mit dem Gate-Anschluss (G) verbunden ist,
- mit einem Drainhalbleitergebiet (11) eines ersten Leitungstyps, das mit dem Drainanschluss (D) verbunden ist,
- mit einem Sourcehalbleitergebiet (12) des ersten Leitungstyps, das mit dem Sourceanschluss (S) verbunden ist,
- mit einem Bodyanschlusshalbleitergebiet (31) eines zweiten Leitungstyps, das mit dem Bodyanschluss (B) verbunden ist,
- mit einem Bodyhalbleitergebiet (30) des zweiten Leitungstyps, das teilweise an das Gate-Oxid (89) zur Ausbildung eines Kanals angrenzt und das an das Bodyanschlusshalbleitergebiet (31) angrenzt,
- mit einem Drifthalbleitergebiet (10) des ersten Leitungstyps, das an das Drainhalbleitergebiet (11) und an das Bodyhalbleitergebiet (30) angrenzt,
wobei im Drifthalbleitergebiet (10) in einem vom Bodyhalbleitergebiet (30) distanzierten Bereich (50) eine Potentialbarriere (pb) ausgebildet ist.

2. Hochvolt-Feldeffekttransistor nach Anspruch 1, bei dem zur Ausbildung der Potentialbarriere (pb) die Bandlücke in diesem Bereich (50) mit der Potentialsbarriere (pb) gegenüber anderen Bereichen des Drifthalbleitergebietes (10) verkleinert ist.

3. Hochvolt-Feldeffekttransistor nach Anspruch 2, bei dem das Drifthalbleitergebiet (10) monokristallines Silizium (Si) aufweist, und bei dem in diesem Bereich (50) in das monokristalline Silizium (Si) des Drifthalbleitergebietes (10) Germaniumatome (Ge) eingebracht sind, wobei in diesem Bereich (50) die Konzentration der Germaniumatome (Ge) in Richtung des Drainhalbleitergebietes (11) abnimmt.

4. Hochvolt-Feldeffekttransistor nach einem der vorhergehenden Ansprüche,
- mit einem Feldoxid (88),
- wobei dieser Bereich (50) mit der Potentialbarriere (pb) an das Feldoxid (88) angrenzt.

5. Hochvolt-Feldeffekttransistor nach einem der vorhergehenden Ansprüche, bei dem die Potentialbarriere (pb) in dem Drifthalbleitergebiet (10) bezüglich einer Chip-Vorderseite ausschließlich oberflächennah, insbesondere in der oberen Hälfte des Drifthalbleitergebietes (10) ausgebildet ist.

6. Hochvolt-Feldeffekttransistor nach einem der vorhergehenden Ansprüche,
- mit einer vergrabenen Isolatorschicht (80), insbesondere aus Siliziumdioxid,
- wobei dieser Bereich (50) mit der Potentialbarriere (pb) vorzugsweise an die vergrabene Isolatorschicht (80) angrenzt.

7. Hochvolt-Feldeffekttransistor nach einem der vorhergehenden Ansprüche, bei dem zusätzlich im Sourcehalbleitergebiet (12) und/oder im Drainhalbleitergebiet (11) eine Potentialbarriere ausgebildet ist.

8. Verfahren zur Herstellung eines Hochvolt-Feldeffekttransistors, bei dem
- ein Drifthalbleitergebiet (10) und ein Bodyhalbleitergebiet (30) aus einem ersten Halbleitermaterial (Si) ausgebildet werden,
- in das Drifthalbleitergebiet (10) ein zweites Halbleitermaterial (Ge) zur Ausbildung einer Potentialbarriere (pb) derart eingebracht wird, dass eine Konzentration des zweiten Halbleitermaterials (Ge) in dem ersten Halbleitermaterial (Si) in Richtung eines Drainhalbleitergebietes (11) abnimmt.

9. Verfahren nach Anspruch 8, bei dem zu einer lateralen Ausbildung der abnehmenden Konzentration des zweiten Halbleitermaterials (Ge) eine Implantationsmaskierung (90) verwendet wird.

10. Verfahren nach Anspruch 8, bei dem zu einer vertikalen Ausbildung der abnehmenden Konzentration des zweiten Halbleitermaterials (Ge) dessen Zufuhr während einer epitaktischen Abscheidung geändert wird.

11. Verfahren nach einem der Ansprüche 8 bis 10, bei dem nach der Potentialbarriere (pb) ein an die Potentialbarriere (pb) angrenzendes Feldoxid (88) ausgebildet wird.
